# EUROPEAN PATENT APPLICATION

(11) **EP 4 815 300 A1**
(43) Date of publication of application: **30.09.2026**
(21) Application number: 25305426.6
(22) Date of filing: 25.03.2025
(51) Int. Cl.: H03F 3/217, H04L 25/02, H03F 3/45

(54) **TRANSMITTER CIRCUIT, TRANSMITTER AND METHOD FOR THE TRANSMITTER**

(71) Applicant: NXP USA, Inc., Austin TX 78735 (US)
(72) Inventor: Cargouet, Yann, 31023 Toulouse Cedex 1 (FR); Mouret, Guillaume, 31023 Toulouse Cedex 1 (FR); Bordes, Laurent, 31023 Toulouse Cedex 1 (FR)
(74) Representative: Schmütz, Christian Klaus Johannes

(57) **Abstract**

The present disclosure relates to a circuit for a transmitter, the circuit comprising: a first supply terminal, a second supply terminal, a first output terminal, a second output terminal, wherein a first circuit string extends from the first supply terminal to a first node of the circuit, wherein a first transistor is integrated in the first circuit string, wherein a second circuit string extends from the second supply terminal to a second node of the circuit, wherein a second transistor is integrated in the second circuit string, wherein a third circuit string extends from the second supply terminal to the first node of the circuit, wherein a third transistor is integrated in the third circuit string, wherein a fourth circuit string extends from the first supply terminal to the second node of the circuit, wherein a second transistor is integrated in the second circuit string, wherein a first connection string extends from the first node to the first output terminal, wherein a first resistor is integrated into the first connection string, and wherein a second connection string extends from the second node to the second output terminal, wherein a second resistor is integrated into the second connection string.

## Description

### TECHNICAL FIELD

The present disclosure relates to a transmitter circuit, a transmitter, and a method for the transmitter

### BACKGROUND

In a wired communication system, at least two communication devices, also referred to as communication nodes, may communicate among each other via a signaling connection. In an example, the communication nodes may communicate communication signals among each other via the signaling connection. The signaling connection via which the communication devices are coupled to each other may be a bus. The communication signals may be electrical voltage signals that represent data. Each communication signal may be given by the course of a differential voltage between two wires of the signaling connection. In an example, the bus may be formed by a twisted pair of wires extending between at least two communication devices. In an example, the signaling connection may be between exactly two communication devices. The transmitter of one of the two communication devices may generate a differential voltage signal that represents data to be transmitted. A receiver of the other communication device may receive the voltage signal and reconstruct the data represented by the received voltage signal.

Disturbances may affect the signaling connection, so that, for example, a disturbance common mode voltage is generated on both wires of the signaling connection. As an effect, the disturbance common mode voltage may reach the transmitter and the sender.

### SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter.

Aspects of the disclosure are defined in the accompanying claims.

In accordance with a first aspect of the present disclosure, a circuit for a transmitter is provided. The circuit comprises a first supply terminal, a second supply terminal, a first output terminal, a second output terminal, wherein a first circuit string extends from the first supply terminal to a first node of the circuit, wherein a first transistor is integrated in the first circuit string, wherein a second circuit string extends from the second supply terminal to a second node of the circuit, wherein a second transistor is integrated in the second circuit string, wherein a third circuit string extends from the second supply terminal to the first node of the circuit, wherein a third transistor is integrated in the third circuit string, wherein a fourth circuit string extends from the first supply terminal to the second node of the circuit, wherein a second transistor is integrated in the second circuit string, wherein a first connection string extends from the first node to the first output terminal, wherein a first resistor is integrated into the first connection string, and wherein a second connection string extends from the second node to the second output terminal, wherein a second resistor is integrated into the second connection string.

In one or more embodiments, each transistor is configured, if a predefined switch-on voltage is applied between a gate terminal of the transistor and a source terminal of the transistor, to form an electrically conductive channel between a source terminal and a drain terminal of the transistor resulting in an active state of the transistor, wherein the conductive channel comprising a predefined electrical conducting impedance.

In one or more embodiments, the conducting impedance of the first transistor is less than a first impedance of the first resistor, and wherein the conducting impedance of the second transistor is less than a second impedance of the second resistor.

In one or more embodiments, the first impedance is at least ten times, at least thirty times or at least hundred times higher than the conducting impedance of the conductive channel of the first transistor, and wherein the second impedance is at least ten times, at least thirty times or at least hundred times higher than the conducting impedance of the conductive channel of the second transistor.

In one or more embodiments, the first transistor is configured as a P-MOS transistor comprising a source terminal being coupled to the first supply terminal, wherein the second transistor is configured as a N-MOS transistor comprising a source terminal being coupled to the second supply terminal, wherein the third transistor is configured as a N-MOS transistor comprising a source terminal being coupled to the second supply terminal, and wherein the fourth transistor is configured as a N-MOS transistor comprising a source terminal being coupled to the first supply terminal.

In one or more embodiments, a capacitor referred to as a decoupling capacitor is coupled between the first supply terminal and the second supply terminal.

In accordance with a third aspect of the present disclosure, a transmitter is provided. The transmitter comprises a circuit according to any of the preceding claims, and a control unit, wherein the gate terminal of each transistor is coupled to the control unit such that each transistor can be controlled by the control unit into each of the following two states: an active state and a passive state.

In one or more embodiments, the conducting impedance of the conductive channel is present at each transistor being in the active state, wherein each of the first and fourth transistor comprising an integrated freewheeling diode with a first transmission direction from its drain terminal to its source terminal, wherein each of the second and third transistor comprising an integrated freewheeling diode with a second transmission direction from its source terminal to its drain terminal, and wherein each transistor is configured, if a predefined switch-off voltage is applied between the gate terminal of the transistor and a source terminal of the transistor, to create a blocking impedance between the drain terminal and the source terminal of the transistor resulting in the passive state of the transistor.

In one or more embodiments, the blocking impedance is at least one thousand times, at least ten thousand times, or at least one hundred thousand times the conducting impedance.

In one or more embodiments, a supply voltage source is coupled between the first supply terminal and the second supply terminal, and wherein the supply voltage source is configured to provide a predefined supply voltage between the two supply terminals.

In one or more embodiments, the control unit is configured to drive the first and second transistors into the active state and to drive the third and fourth transistors into the passive state resulting in a positive differential voltage between the first and second output terminals.

In one or more embodiments, the control unit is configured to drive the first and second transistors into the passive state and to drive the third and fourth transistors into the active state resulting in a negative differential voltage between the first and second output terminals.

In one or more embodiments, a common mode voltage source is coupled between the first output terminal and the second output terminal, wherein the common mode voltage source is configured to provide a predefined common mode voltage at both output terminals.

In accordance with a third aspect of the present disclosure, a method for a transmitter is provided. The method comprises the steps of: (a) driving the first and second transistors into the active state and the third and fourth transistors into the passive state, (b) driving the first and second transistors into the passive state and the third and fourth transistors into the active state, and (c) driving the first to fourth transistors into the passive state.

In one or more embodiments, each transistor is configured, if a predefined switch-on voltage is applied between a gate terminal of the transistor and a source terminal of the transistor, to form an electrically conductive channel between a source terminal and a drain terminal of the transistor resulting in an active state of the transistor, wherein the conductive channel comprising a predefined electrical conducting impedance, wherein the conducting impedance of the first transistor is less than a first impedance of the first resistor, and wherein the conducting impedance of the fourth transistor is less than a second impedance of the second resistor.

### DESCRIPTION OF DRAWINGS

Embodiments of the present disclosure will be described in more detail with reference to the appended drawings. It is to be noted, however, that the appended drawings illustrate only typical embodiments of the present disclosure and are therefore not to be considered limiting of its scope, such that other equally effective embodiments may be implemented. Advantages of the subject matter claimed will become apparent to those skilled in the art upon reading this description in conjunction with the accompanying drawings, in which like reference numerals have been used to designate like elements, and in which:
Figure 1 shows an example of a simplified block diagram of a transmitter circuit and a transmitter.
Figure 2 shows a simplified voltage diagram.
Figure 3 to 8 shows further examples of the simplified block diagram of the transmitter circuit and the transmitter.
Figure 9 shows a simplified flow chart of the method for the transmitter.

### DESCRIPTION OF EMBODIMENTS

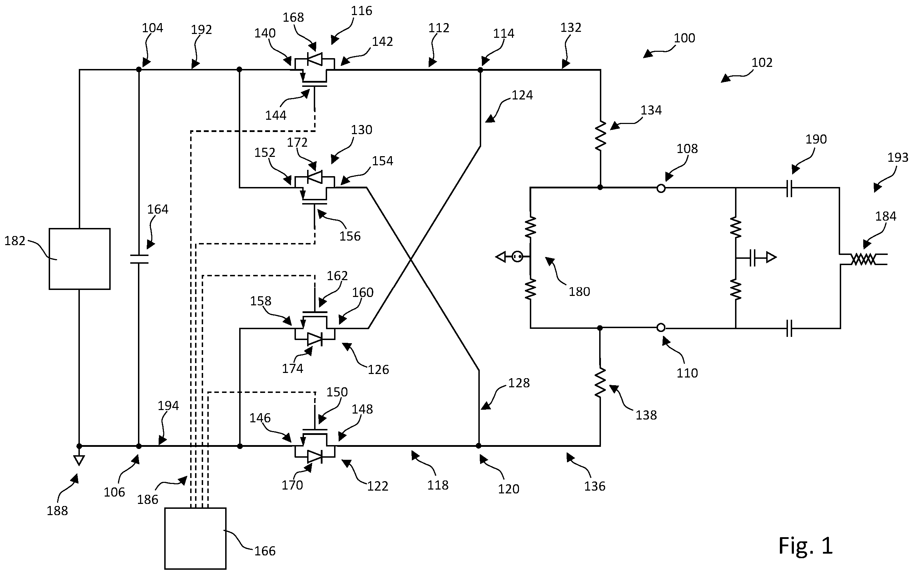

Figure 1 schematically shows an example of a circuit 100 for a transmitter 102. The circuit 100 for the transmitter 102 may also be referred to as the transmitter circuit 100.

Furthermore, an example of a transmitter 102 is shown schematically in Figure 1. The transmitter circuit 100 may be a separate component, in particular configured as a separate transmitter device, or as a part of the transmitter 102 of a communication device (not shown). The following explanations may refer to both configurations of the transmitter circuit 100.

The transmitter circuit 100 should be robust against a disturbance common mode voltage, which may be passed to the transmitter circuit 100, for example, via a transmission lines. The robustness with respect to a disturbance common mode voltage allows for a high data rate and/or a small error rate. Furthermore, the transmitter circuit 100 should be compact so that the transmitter circuit 100 takes up little space. It is advantageous if low-cost components can be used to manufacture the transmitter circuit 100. In particular, it is advantageous if the use of cost-intensive components and/or a large number of components to achieve robustness against disturbance common mode voltages can be avoided. At the same time, it is desirable if the transmitter circuit 100 can be controlled to generate different differential voltage output signals.

For example, communication devices are used in vehicle battery management systems. Each of the communication devices may comprise a transmitter 102. For example, point-to-point communication between two communication devices via a bus 193 extending between the two communication devices may be achieved for the battery management system. In Figure 1, only part of an exemplary embodiment of a bus 193 is shown schematically. The bus 193 may comprise a twisted pair of wires 184. Furthermore, the bus 193 may be galvanically isolated from the transmitter circuit 100 and/or the transmitter 102 of a communication device, for example by capacitors 190.

The transmitter circuit 100 comprises a first output terminal 108 and a second output terminal 110. The two output terminals 108, 110 may also be referred to as the output of the transmitter circuit 100 and/or the transmitter 102. In an example, the transmitter circuit 100 may be configured to be controlled such that the transmitter circuit 100 generates a differential voltage, also referred to as differential output voltage, between the two output terminals 108, 110. In an example, the transmitter circuit 100 may be configured to be controlled so that the transmitter circuit 100 can generate the differential output voltage at three different voltage levels. For example, the transmitter circuit 100 may be configured to generate the differential output voltage at a first voltage level 202, for example at -2V. Furthermore, the transmitter circuit 100 may be configured to generate the differential output voltage with a second voltage level 204, for example at 0V. In an example, the transmitter circuit 100 may be configured to generate the differential output voltage with a third voltage level 206, for example at 2 V. The stated values for the voltage levels may be adapted for the respective application.

To simulate a disturbance of the bus 193, a predefined common mode voltage of 20 V may be generated at each of the two output terminals 108, 110 in a first test. The common mode voltage generated for the first test may also be referred to as the first test common mode voltage. In the prior art, high-voltage diodes and high-voltage transistors are used for transmitters that can withstand the first test common mode voltage without destruction. For example, a high-voltage diode may be understood to mean a diode that can withstand a voltage of at least 25 V or at least 30 V without destruction. A high-voltage transistor may be understood, for example, to be a transistor that can withstand a voltage of at least 25 V or at least 30 V without being destroyed.

Using high-voltage diodes and/or high-voltage transistors for a transmitter is expensive. In addition, high-voltage diodes and/or high-voltage transistors take up a lot of space in the transmitter.

The transmitter circuit 100 of the present publication, as shown schematically in figure 1, for example, may be manufactured without high-voltage diodes and without high-voltage transistors. As an effect, the transmitter circuit 100 of the present publication may be manufactured in a cost-effective and compact manner and with few components, wherein the transmitter circuit 100 offers a high degree of robustness against common mode disturbance.

As previously explained, the transmitter circuit 100 comprises the first output terminal 108 and the second output terminal 110. In addition, the transmitter circuit 100 comprises further terminals 104, 106, which are referred to as the first supply terminal 104 and the second supply terminal 106. If the transmitter circuit 100 forms part of a transmitter 102 that does not form part of a further circuit, in particular an integrated circuit, then each of the terminals 104-106 may be configured as a terminal as such. If the transmitter circuit 100 forms part of a transmitter 102 that is, for example, configured on a printed circuit board or that forms part of an integrated circuit, then each of the terminals 104-106 may form a node in a circuit network of the transmitter 102.

In an example, the transmitter circuit 100 may be supplied with an input voltage across the two supply terminals 104, 106. The input voltage may comprise a predefined voltage level. The transmitter 102 may comprise a voltage source 182. The voltage source 182 may be a DC voltage source. The DC voltage source 182 may be coupled to the two supply terminals 104, 106 so that a predefined DC voltage is present between the two supply terminals 104, 106.

The transmitter circuit 100 comprises a first circuit string 112, a second circuit string 118, a third circuit string 124, and a fourth circuit string 128. Each circuit string 112, 118, 124, 128 may be understood in an example as a string of the transmitter circuit 100, wherein one or more electrical components may be integrated into each string. An electrical component may be, for example, a resistor, a capacitor, a transistor, a diode, or another passive or active electrical component. If multiple electrical components are integrated into a string, the components may be coupled to one another in a series circuit, in a parallel circuit, or in another network topology in the string.

The first circuit string 112 extends from the first supply terminal 104 to a first node 114 of the transmitter circuit 100. A first transistor 116 is integrated into the first circuit string 112. In an example, further electrical components may be integrated into the first circuit string 112. If further electrical components are integrated into the first circuit string 112, then it may be the case that none of the further electrical components are coupled in parallel with the first transistor 116.

The second circuit string 118 extends from the second supply terminal 106 to a second node 120 of the transmitter circuit 100. The first node 114 and the second node 120 are different nodes of the transmitter circuit 100. A second transistor 122 is integrated into the second circuit string 118. In an example, further electrical components may be integrated into the second circuit string 118. If further electrical components are integrated into the second circuit string 118, then it may be the case that none of the further electrical components is coupled in parallel with the second transistor 122.

A third circuit string 124 extends from the second supply terminal 106 to the first node 114 of the transmitter circuit 100. A third transistor 126 is integrated into the third circuit string 124. In an example, further electrical components may be integrated into the third circuit string 124. If further electrical components are integrated into the third circuit string 124, then it may be the case that none of the further electrical components is coupled in parallel with the third transistor 126.

In an example, the second circuit string 118 and the third circuit string 124 may comprise a section 194 that is formed jointly by the second and third circuit strings 118, 124. The jointly formed section 194 comprises neither the second transistor 122 nor the third transistor 126. The second transistor 122 may be integrated into the second circuit string 118 outside the jointly formed section 194. The third transistor 126 may be integrated into the third circuit string 124 outside the jointly formed section 194.

The fourth circuit string 128 extends from the first supply terminal 104 to the second node 120 of the transmitter circuit 100. A fourth transistor 130 is integrated into the fourth circuit string 128. In an example, further electrical components may be integrated into the fourth circuit string 128. If further electrical components are integrated into the fourth circuit string 128, then it may be the case that none of the further electrical components is coupled in parallel with the fourth transistor 130.

In an example, the first circuit string 112 and the fourth circuit string 128 may comprise a section 192 that is formed jointly by the first and fourth circuit strings 112, 128. The jointly formed section 192 comprises neither the first transistor 116 nor the fourth transistor 130. The first transistor 116 may be integrated into the first circuit string 112 outside of the jointly formed section 192. The fourth transistor 130 may be integrated into the fourth circuit string 128 outside of the jointly formed section 192.

The transmitter circuit 100 further comprises a first connection string 132 and a second connection string 136. Each connection string 132, 136 may be understood, in an example, as a string of the transmitter circuit 100, wherein one or more electrical components may be integrated into each connection string 132, 136. If multiple electrical components are integrated into a connection string 132, 136, the components may be coupled to one another in a series connection, in a parallel connection, or in another network topology in the string.

The first connection string 132 extends from the first node 114 to the first output terminal 108. A first resistor 134 is integrated into the first connection string 132. The first resistor 134 may comprise a predefined impedance. The impedance of the first resistor 134 may also be referred to as a first impedance. In an example, further electrical components may be integrated into the first connection string 132.

The second connection string 136 extends from the second node 120 to the second output terminal 110. A second resistor 138 is integrated into the second connection string 136. The second resistor 138 may comprise a predefined impedance. The impedance of the second resistor 138 may also be referred to as the second impedance. In an example, further electrical components may be integrated into the second connection string 136.

The first resistor 134 in the first connection string 132 and the second resistor 138 in the second connection string 136 offer the possibility that a common mode voltage, if it is present at the output terminals 108, 110, can drop mainly at the two resistors 134, 138. In an example, the first resistor 134 may be configured such that at least 50%, at least 60%, or at least 70% of a common mode voltage, if present at the first output terminal 108, drops across the first resistor 134. In an example, the second resistor 138 may be configured such that at least 50%, at least 60%, or at least 70% of a common mode voltage, if present on the second output terminal 110, drops across the second resistor 138.

Assuming that the two resistors 134, 138 are configured so that a significant portion of a disturbance common mode voltage that may be present at the output terminals 108, 110 drops across the two resistors 134, 138, it is possible that the first, second, third, fourth transistors 116, 122, 126, 130 are protected from a high portion of the disturbance common mode voltage. As an effect, the first to fourth transistors 116, 122, 126, 130 may be comprised of only a low voltage robustness. In an example, the first to fourth transistors 116, 122, 126, 130 may each be constructed such that each of the transistors 116, 122, 126, 130 provides robustness only up to a predefined reference voltage, such as 10V, 7.5V, or 5V. The reference voltage may be a small voltage because the larger portion of the disturbance common mode voltage drops across resistors 134, 138. Due to the lower reference voltage for transistors 116, 122, 126, 130, it is possible that transistors 116, 122, 126, 130 comprise a small size. Furthermore, in the first to fourth circuit strings 112, 118, 124, 128 further active or passive components, which in particular serve to protect against a disturbance common mode voltage, may be superfluous and/or prevented. As an effect, it is possible that the transmitter circuit 100 comprises only a few active components, in particular only a few transistors 116, 122, 126, 130. In the example from Figure 1, the transmitter circuit 100 comprises only four transistors 116, 122, 126, 130. In an example, no further transistors are necessary for the transmitter circuit 100. The transmitter circuit 100 is therefore compact, cost-effective, and robust against common mode voltages.

The first transistor 116 is in particular a MOS transistor. In an example, the first transistor 116 is configured as a P-MOS transistor. The first transistor 116 may comprise a first source terminal 140, a first drain terminal 142, and a first gate terminal 144. The first source terminal 140 may be coupled to the first supply terminal 104. The first drain terminal 142 may be coupled to the first node 114.

The second transistor 122 is in particular a MOS transistor. In an example, the second transistor 122 is configured as an N-MOS transistor. The second transistor 122 may comprise a second source terminal 146, a second drain terminal 148, and a second gate terminal 150. The second source terminal 146 may be coupled to the second supply terminal 106. The second drain terminal 148 may be coupled to the second node 120.

The third transistor 126 is in particular an MOS transistor. In an example, the third transistor 126 is configured as an N-MOS transistor. The third transistor 126 may comprise a third source terminal 158, a third drain terminal 160, and a third gate terminal 162. The third source terminal 158 may be coupled to the second supply terminal 106. The third drain terminal 160 may be coupled to the first node 114.

The fourth transistor 130 is in particular a MOS transistor. In an example, the fourth transistor 130 is configured as a P-MOS transistor. The fourth transistor 130 may comprise a fourth source terminal 152, a fourth drain terminal 154, and a fourth gate terminal 156. The fourth source terminal 152 may be coupled to the first supply terminal 104. The fourth drain terminal 154 may be coupled to the second node 120.

It was previously explained that Figure 1 also schematically illustrates an example of the transmitter 102. The transmitter 102 comprises the transmitter circuit 100. In addition, the transmitter 102 comprises a control unit 166. The first to fourth gate terminals 144, 150, 156, 162 may each be coupled to the control unit 166. In Figure 1, associated control lines 186 are schematically indicated by dashed lines. The first to fourth transistors 116, 122, 126, 130 may each be controlled by the control unit 166 into each of the following two states: active state and passive state. In an example, the control unit 166 may be configured to drives each of the four transistors 116, 122, 126, 130 independently of one another via the respective gate terminals 144, 150, 15, 162 either in the active state or in the passive state.

The transmitter 102 may also comprise a voltage source 182. The voltage source 182 may also be referred to as a DC voltage source 182 or a DC source 182. The DC voltage source 182 may be coupled between the first supply terminal 104 and the second supply terminal 106. Furthermore, the DC voltage source 182 may be configured to generate a predefined voltage between the two supply terminals 104, 106. The voltage may be a DC voltage. The voltage generated between the two supply terminals 104, 106 by the DC voltage source 182 may also be referred to as the supply voltage. For example, the supply voltage may be between 3V and 7V. In an example, the supply voltage may be 5V.

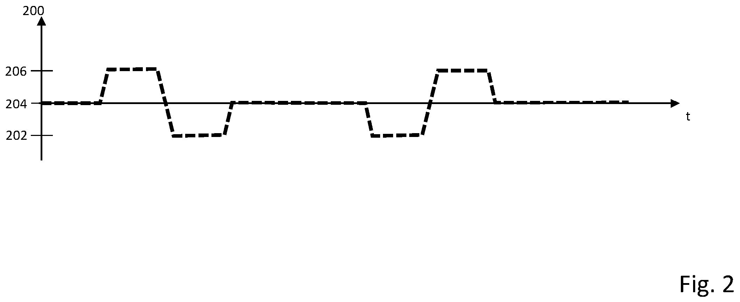

In an example, the controller 166 of the transmitter 102 may be configured to control the first to fourth transistors 116, 122, 126, 130 such that the transmitter 102 generates an output voltage between the output terminals 108, 110. In an example, the controller 166 may be configured to control the first to fourth transistors 116, 122, 126, 130 such that the transmitter 102 generates as the output voltage one of three predefined differential voltages 202, 204, 206. Figure 2 schematically shows an example of a signal curve of the output voltage 200. The differential voltage that can be generated as the output voltage can be the first differential voltage 202, the second differential voltage 204 or the third differential voltage 206. The second differential voltage 204 may be greater than the first differential voltage 202. The third differential voltage 206 may be greater than the second differential voltage 204.

In an example, the transmitter 102 may comprise a further voltage source 180, also referred to as a common mode voltage source 180. The common mode voltage source 180 may be configured to generate a predefined reference common mode voltage at both output terminals 108, 110. In an example, the common mode voltage source 180 may be configured to generate a voltage between 1V and 4V, in particular a voltage of 2.5V, as the reference common mode voltage at both output terminals 108, 110.

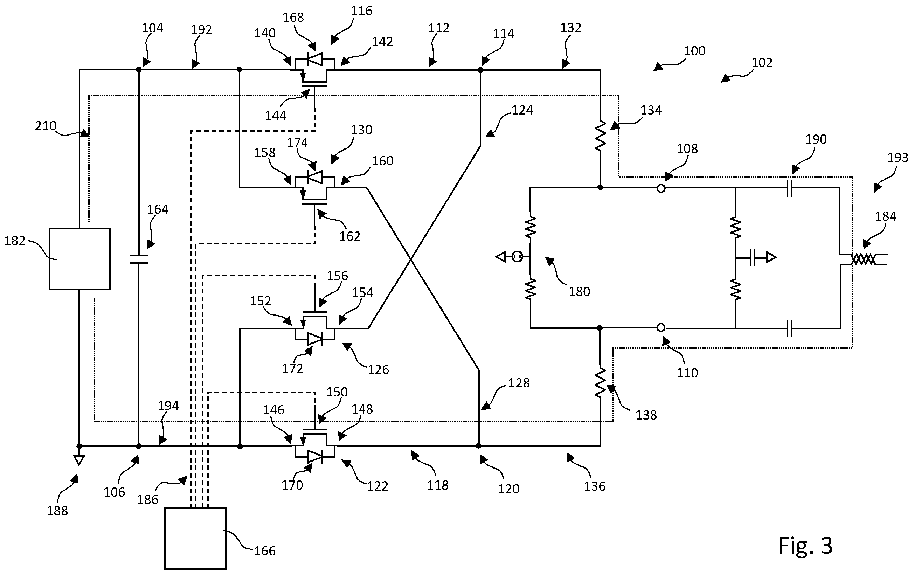

In an example, the control unit 166 may be configured to drive the first and fourth transistors 116, 122 to the active state and the second and third transistors 126, 130 to the passive state, such that the third differential voltage 206 drops across the two output terminals 108, 110. The third differential voltage 206 may be, for example, 2V. If the first and fourth transistors 116, 122 are in the active state and the second and third transistors 126, 130 are in the passive state, then the transmitter 102 may be in a first operating state. Figure 3 illustrates an example of the transmitter 102 from Figure 1, wherein Figure 3 also schematically shows a possible first current path during the first operating state by means of a first dotted line 210. Starting from the DC voltage source 182, the first dotted line 210 leads via the first supply terminal 104 to the first source terminal 140 of the first transistor 116. The control unit 166 may control the first transistor 116 via the first gate terminal 144 such that the first transistor 116 is in the active state. As a result, current may flow between the first source terminal 140 and the first drain terminal 142. As an effect, the first dotted line 210 leads from the first source terminal 140 via the first drain terminal 142 to the first node 114. From the first node 114, the first dotted line 210 leads via the first resistor 134 to the first output terminal 108. From the first output terminal 108, the first dotted line 210 leads via the possibly coupled bus 193 to the second output terminal 110. From the second output terminal 110, the first dotted line 210 leads via the second resistor 138 to the second node 120. From the second node 120, the first dotted line 210 to the second drain terminal 148 of the second transistor 122. The controller 166 may control the second transistor 122 via the second gate terminal 150 such that the second transistor 122 is in the active state. As a result, current may flow between the second drain terminal 148 and the second source terminal 146. As an effect, the first dotted line 210 leads from the second drain terminal 148 via the second source terminal 146 to the second supply terminal 106. From the second supply terminal 106, the first dotted line 210 leads back to the DC voltage source 182. To generate the third differential voltage 206 between the two output terminals 108, 110, the current may flow along the first dotted line 210.

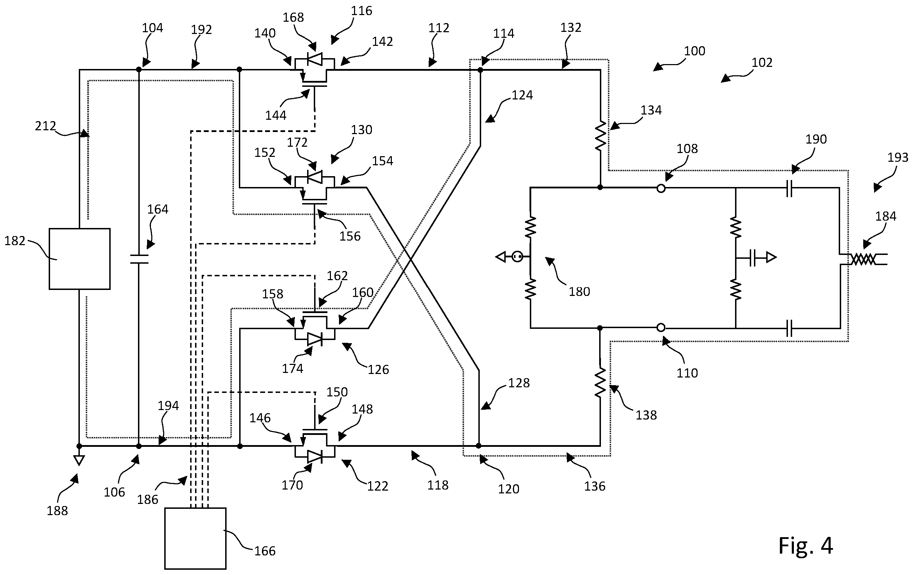

In an example, the control unit 166 may be configured to drive the first and fourth transistors 116, 122 to the passive state and the second and third transistors 126, 130 to the active state such that the first differential voltage 202 drops across the two output terminals 108, 110. The first differential voltage 202 may be, for example, -2V. If the first and fourth transistors 116, 122 are in the passive state and the second and third transistors 126, 130 are in the active state, then the transmitter 102 may be in a second operating state. Figure 4 is a further illustration of the transmitter 102 from Figure 1, wherein a possible second current path during the second operating state is also schematically illustrated in Figure 4 by a second dotted line 212. Starting from the DC voltage source 182, the second dotted line 212 leads via the first supply terminal 104 to the third source terminal 152 of the fourth transistor 130. The control unit 166 may control the fourth transistor 130 via the fourth gate terminal 156 such that the fourth transistor 130 is in the active state. As a result, current may flow between the fourth source terminal 152 and the fourth drain terminal 154. As an effect, the second dotted line 212 leads from the fourth source terminal 152, via the fourth drain terminal 154, the second node 120, and the second resistor 138 to the second output terminal 110. From the second output terminal 110, the second dotted line 212 leads via the possibly coupled bus 193 to the first output terminal 108. From the first output terminal 108, the second dotted line 212 leads via the first resistor 134 to the first node 114. From the first node 114, the second dotted line 212 leads to the third drain terminal 160 of the third transistors 126. The control unit may control the third transistor 126 via the third gate terminal 162 such that the third transistor 126 is in the active state. As a result, current may flow between the third drain terminal 160 and the third source terminal 158. As an effect, the second dotted line 212 leads from the third drain terminal 160 via the third source terminal 158 to the second supply terminal 106. From the second supply terminal 106, the second dotted line 212 leads back to the DC voltage source 182. To generate the first differential voltage 202 between the two output terminals 108, 110, the current may flow along the second dotted line 212.

In an example, the controller 166 may be configured to drive the first to fourth transistors 116, 122, 126, 130 to the passive state such that the second differential voltage 204 drops across the two output terminals 108, 110. In this case, no current flow is caused by the DC voltage source 182. In an example, the second differential voltage may be 0 V. As an effect, the reference common mode voltage generated by the common mode voltage source 180 may be present at both output terminals 108, 110. If all four transistors 116, 122, 126, 130 are in the passive state, then the reference common mode voltage may create the second voltage level 204 at the output terminals 108, 110. If at least two of the transistors 116, 122, 126, 130 are in the active state (in particular while the other two transistors 116, 122, 126, 130 are in the passive state), then the differential output voltage may be generated through both sources, the common mode source 180 and the voltage source 182.

To represent a logical 1 bit by the output voltage between the two output terminals 108, 110, the control unit 166 may control the transmitter 102 such that the third differential voltage 206, the first differential voltage 202, and the second differential voltage 204 are generated in succession as the output voltage. The aforementioned sequence of the three different differential voltages 206, 202, 204 may represent the logical 1 bit. To represent a logical 0 bit by the output voltage between the two output terminals 108, 110, the control unit 166 may control the transmitter 102 to generate the first differential voltage 202, the third differential voltage 206, and the second differential voltage 204 as output voltage in succession. The aforementioned sequence of the three different differential voltages 202, 206, 204 may be the logical 0 bit.

It was explained earlier that the first and second resistors 134, 138 may protect the transistors 116, 122, 126, 130 from excessive voltage stress due to a disturbance common mode voltage.

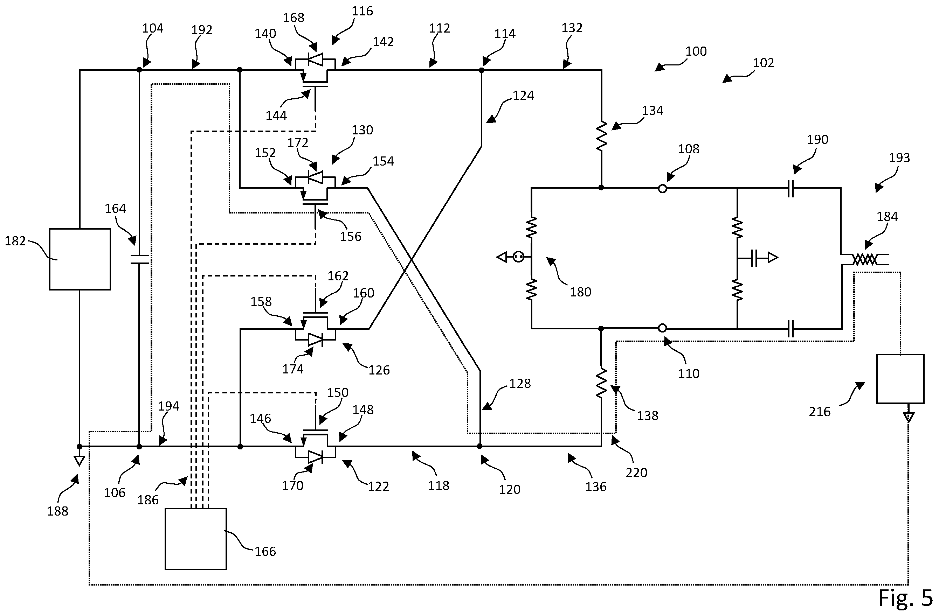

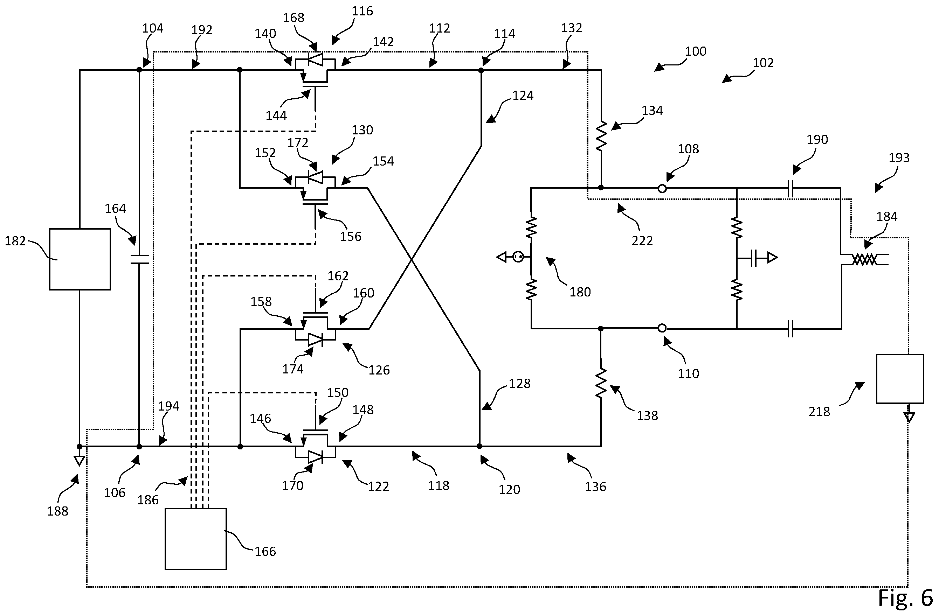

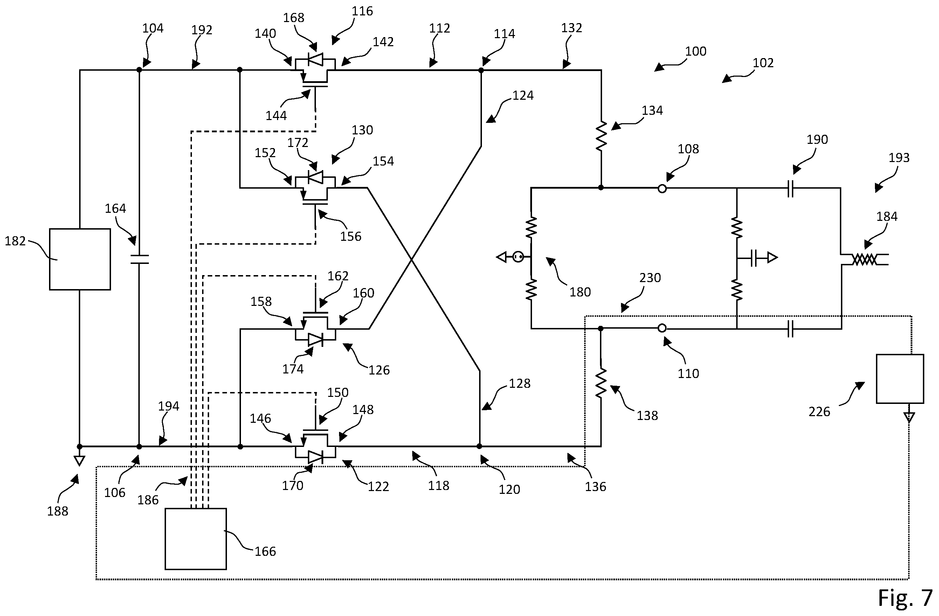

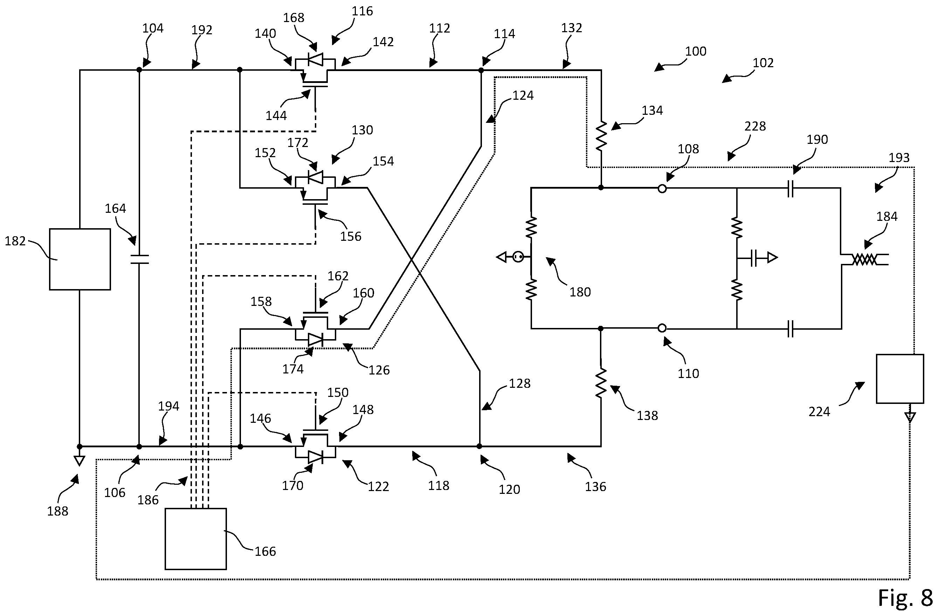

In the following, the protective effect of the resistors 134, 138 is explained in connection with examples if all four transistors 116, 122, 126, 130 are in the passive state and a disturbance common mode voltage is present at the two output terminals 108, 110. Protection from disturbance common mode voltage at the second output terminal 110 is explained in conjunction with Figures 5 and 7. Protection from disturbance common mode voltage at the first output terminal 108 is explained in conjunction with Figures 6 and 8.

In the example in Figure 5, a first disturbance common mode voltage at the second output terminal 110 is caused by a first disturbance common mode source 216. To simulate the first disturbance common mode voltage at the second output terminal 110, it may be theoretically assumed that the first disturbance voltage source 216 is coupled between the second output terminal 110 and a reference terminal 188. In this example, it is assumed that the first disturbance common mode voltage is a positive voltage, such as 20V. The reference terminal 188 may be, for example, at a reference or ground potential. The first disturbance common mode voltage causes a first disturbance current. The path of the first disturbance current is represented by the third dotted line 220. From the first disturbance voltage source 216, the first disturbance current flows via the second output terminal 110 and the second resistor 138 to the second node 120. From the second node 120, the first disturbance current flows via the fourth connection string 128 to the first input terminal 104. The fourth transistor 130, which is integrated into the fourth connection string 128, may comprise an integrated freewheeling diode 172. The fourth transistor 130 may be configured as an P-MOS transistor. The integrated freewheeling diode 172 of the fourth transistor 130 may also be referred to as the fourth freewheeling diode 172. The fourth freewheeling diode 172 may be formed by a p-n junction within the fourth transistor 130. The fourth freewheeling diode 172 comprises a freewheeling direction from the fourth drain terminal 154 to the fourth source terminal 152. A current may flow via the fourth freewheeling diode 172 in the freewheeling direction. Even if the fourth transistor 130 is in the passive state in the example, the first disturbance current may flow via the fourth freewheeling diode 172 from the second node 120 to the first supply terminal 104. In an example, a capacitor 164 may be coupled between the first input terminal 104 and the second input terminal 106. The capacitor 164 may also be referred to as a decoupling capacitor 164. From the first input terminal 104, the first disturbance current may flow via the capacitor 164 and/or via the DC voltage source 182 to the reference terminal 188. The reference terminal 188 may be coupled to the second input terminal 106. From the first reference terminal 188, the first disturbance current may flow in particular via ground or another coupling to the first disturbance voltage source 216.

In the freewheeling direction, the fourth freewheeling diode 172 may comprise a predefined impedance, also referred to as fourth freewheeling impedance. The fourth freewheeling impedance may be less than a second impedance of the second resistor 138. As an effect, a larger portion of the first disturbance common mode voltage drops across the second resistor 138. A smaller portion of the first disturbance common mode voltage may drop across the fourth freewheeling diode 172. In an example, the second impedance (of the second resistor 138) is at least ten times, at least thirty times, or at least one hundred times greater than the fourth freewheeling impedance. For example, the second impedance may be between ten times and one thousand times the fourth freewheeling impedance. As an effect, only a very small portion of the first disturbance common mode voltage drops across the fourth freewheeling diode 172 and the largest portion of the first disturbance common mode voltage drops across the second resistor 138. The portion of the first disturbance common mode voltage that drops across the fourth freewheeling diode 172 may be so small that the fourth transistor 130 needs only a low disturbance robustness with respect to a disturbance common mode voltage. As an effect, the fourth transistor 130 may have a small size and/or may be manufactured with low costs.

In an example shown in Figure 6, the disturbance common mode voltage is a second disturbance common mode voltage at the first output terminal 108 caused by a second disturbance voltage source 218. The first and second disturbance common mode voltages may be the same. To simulate the second disturbance common mode voltage at the first output terminal 108, it may be theoretically assumed that the second disturbance voltage source 218 is coupled between the first output terminal 108 and the reference terminal 188. In this example, it is assumed that the second disturbance common mode voltage is a positive voltage, such as 20 V. The second disturbance common mode voltage causes a second disturbance current. The path of the second disturbance current is represented by the fourth dotted line 222. From the second disturbance voltage source 218, the second disturbance current flows via the first output terminal 108 and the first resistor 134 to the first node 114. From the first node 114, the second disturbance current flows via the first connection string 112 to the first input terminal 104. The first transistor 116, which is integrated in the first connection string 112, may comprise an integrated freewheeling diode 168. The first transistor 116 may be configured as a P-MOS transistor. The integrated freewheeling diode 168 of the first transistor 116 may also be referred to as a first freewheeling diode 168. The first freewheeling diode 168 may be formed by a p-n junction within the first transistor 116. The first freewheeling diode 168 comprises a freewheeling direction from the first drain terminal 142 to the first source terminal 140. A current may flow via the first freewheeling diode 168 in the freewheeling direction. Even if the first transistor 116 is in the passive state in the example, the second disturbance current may flow via the first freewheeling diode 168 from the first node 114 to the first supply terminal 104. From the first input terminal 104, the second disturbance current may flow to the reference terminal 188 via the capacitor 164 and/or via the DC voltage source 182. From the first reference terminal 188, the second disturbance current may flow in particular via the ground or another coupling to the second disturbance voltage source 218.

In the freewheeling direction, the first freewheeling diode 168 may comprise a predefined impedance, also referred to as the first freewheeling impedance. The first freewheeling impedance may be less than a first impedance of the first resistor 134. As an effect, a larger portion of the second disturbance common mode voltage drops across the first resistor 134. A smaller portion of the second disturbance common mode voltage can drop across the first freewheeling diode 168. In an example, the first impedance (of the first resistor 134) is at least ten times, at least thirty times, or at least one hundred times greater than the first freewheeling impedance. For example, the first impedance may be between 10 times and 1000 times the first freewheeling impedance. As an effect, only a very small portion of the second disturbance common mode voltage drops across the first freewheeling diode 168 and the largest portion of the second disturbance common mode voltage drops across the first resistor 134. The portion of the common mode voltage that drops across the first freewheeling diode 168 may be so small that the first transistor 116 needs only low disturbance robustness with respect to a disturbance common mode voltage. As an effect, the first transistor 116 may have a small size and/or may be manufactured with low costs.

In connection with Figures 5 and 6, examples of the effects of a positive common mode voltage were explained, which can occur due to disturbances at the two output terminals 108, 110. From the two output terminals 108, 110 different paths 220, 222 of the disturbance currents caused by the positive common mode voltage may be created in the transmitter circuit. If, instead of the positive disturbance common mode voltage, a negative disturbance common mode voltage is caused by other disturbances at the two output terminals 108, 110, then other paths 228, 230 of the disturbance currents may be created in the transmitter circuit 100. Examples of the other paths 228, 230 are shown schematically in Figures 7 and 8. Furthermore, disturbance voltage sources 224, 226 are shown schematically in Figures 7 and 8, which may simulate the negative disturbance common mode voltage. With respect to Figures 7 and 8, reference is made to the preceding explanations of advantageous features, technical effects and advantages in a manner analogous to that explained in connection with Figures 5 and 6.

In the example in Figure 7, a third disturbance common mode voltage is caused at the second output terminal 110 by a third disturbance voltage source 226. To simulate the third disturbance common mode voltage at the second output terminal 110, it may be theoretically assumed that the third disturbance voltage source 226 is coupled between the second output terminal 110 and the reference terminal 188. In this example, the third disturbance common mode voltage is assumed to be a negative voltage, such as -20V. The third disturbance common mode voltage causes a third disturbance current. The path of the third disturbance current is represented by the fourth dotted line 230. From the third disturbance voltage source 226, the disturbance current flows via the reference terminal 188 to the second input terminal 106. From the second input terminal 106, the third disturbance current flows via the second circuit string 118 to the second node 120. The second transistor 122, which is integrated in the second connection string 118, may comprise an integrated freewheeling diode 170. The second transistor 122 may be configured as a N-MOS transistor. The integrated freewheeling diode 170 of the second transistor 122 may also be referred to as a second freewheeling diode 170. The second freewheeling diode 170 may be formed by a p-n junction within the second transistor 122. The second freewheeling diode 170 comprises a freewheeling direction from the second source terminal 146 to the second drain terminal 148. A current may flow via the second freewheeling diode 170 in the freewheeling direction. Even if the second transistor 122 is in the passive state in the example, the third disturbance current may flow via the second freewheeling diode 170 from the second input terminal 106 to the second node 120. From the second node 120, the third disturbance current may flow via the second resistor 138 to the second output terminal 110. From the second output terminal 110, the third disturbance current may flow to the third disturbance voltage source 226.

In the freewheeling direction, the second freewheeling diode 170 may comprise a predefined impedance, also referred to as the second freewheeling impedance. The second freewheeling impedance may be less than the second impedance of the second resistor 138. As an effect, a larger portion of the third disturbance common mode voltage drops across the second resistor. A smaller portion of the third disturbance common mode voltage may drop across the second freewheeling diode 170. In an example, the second impedance (of the second resistor 138) is at least ten times, at least thirty times, or at least one hundred times greater than the second freewheeling impedance. For example, the second impedance may be at least ten times or at least one thousand times the second freewheeling impedance. As an effect field, only a very small portion of the third disturbance common mode voltage drops across the second freewheeling diode 170 and most of the third disturbance common mode voltage drops across the second resistor 138. The portion of the third disturbance common mode voltage that drops across the second freewheeling diode 170 may be so small that the second transistor 122 needs only a low disturbance robustness against a disturbance common mode voltage. As an effect, the second transistor 122 may be manufactured in a small and cost-effective manner.

In an example shown in Figure 8, a fourth disturbance common mode voltage at the first output terminal 108 is caused by a fourth disturbance voltage source 224. To simulate the fourth disturbance common mode voltage at the first output terminal 108, it may be theoretically assumed that the fourth disturbance voltage source 224 is coupled between the first output terminal 108 and the reference terminal 188. In this example, it is assumed that the fourth disturbance common mode voltage is a negative voltage, such as -20V. The fourth disturbance common mode voltage causes a fourth disturbance current. The path of the fourth disturbance current is represented by the fourth dotted line 228. Starting from the reference terminal 188, the fourth disturbance current may flow from the reference terminal 188 to the second input terminal 106. From the second input terminal 106, the fourth disturbance current may flow via the third connection 124 to the first node 114. The third transistor 126 integrated into the third connection string 124 may comprise an integrated freewheeling diode 174. The third transistor 126 may be configured as a N-MOS transistor. The integrated freewheeling diode 174 of the third transistor 126 may also be referred to as a third freewheeling diode 174. The third freewheeling diode 174 may be formed by a P-N-type junction within the third transistor 126. The third freewheeling diode 174 comprises a freewheeling direction from the third source terminal 158 to the third drain terminal 160. In the freewheeling direction, a current may flow via the third freewheeling diode 174. Even if the third transistor 126 is in the passive state in the example, the fourth disturbance current may flow via the third freewheeling diode 174 from the second input terminal 106 to the first node 114. From the first node 114, the fourth disturbance current may flow via the first resistor 134 to the first output terminal 108. From the first output terminal 108, the fourth disturbance current may flow to the fourth disturbance voltage source 224.

In the freewheeling direction, the third freewheeling diode 174 may comprise a predefined impedance, also referred to as the third freewheeling impedance. The third freewheeling impedance may be less than the first impedance of the first resistor 134. As an effect, a larger portion of the fourth disturbance common mode voltage drops across the first resistor 134. A smaller portion of the fourth disturbance common mode voltage may drop across the third freewheeling diode 174. In an example, the first impedance (of the first resistor 134) is at least ten times, at least thirty times, or at least one hundred times greater than the third freewheeling impedance. For example, the first impedance may be between 10 times and 1000 times of the third freewheeling impedance. As an effect, only a very small portion of the fourth disturbance common mode voltage drops across the third freewheeling diode 174 and most of the fourth disturbance common mode voltage drops across the first resistor 134. The portion of the fourth disturbance common mode voltage that drops across the third freewheeling diode 174 may be so small that the third transistor 126 only needs a low disturbance robustness to disturbance common mode voltage. As an effect, the third transistor 126 may be manufactured in a compact and cost effective manner

For the above examples given in connection with Figures 5-8, it is assumed that each of the transistors 116, 122, 126, 130 is in a passive state. Each of the transistors 116, 122, 126, 130 may be configured, if an associated switch-off voltage is applied between the respective gate terminal 144, 150, 156, 162 and the respective source terminal 140, 146, 152, 158, to create a blocking impedance between the respective drain terminal 142, 148, 154, 160 and the respective source terminal 140, 146, 152, 158, so that the respective transistor 116, 122, 126, 130 is in the passive state. The blocking impedance may be so great that a current flow is substantially prevented, in particular between the drain terminal 142, 148, 154, 160 and the source terminal 140, 146, 152, 158. Due to the large blocking impedance, an associated conductive channel through the respective transistor 116, 122, 126, 130 may be interrupted. The aforementioned features may be customized for each transistor 116, 122, 126, 130 individually. For example, the first transistor 116 may be configured such that if a predefined first switch-off voltage is applied between the first gate terminal 144 and the first source terminal 140, the first transistor 116 creates a first blocking impedance between the first drain terminal 142 and the first source terminal 140. As a result of the first blocking impedance being created, the first transistor 116 changes to the passive state. In a further example, the second transistor 122 may be configured such that, if a predefined second switch-off voltage is applied between the second gate terminal 150 and the second source terminal 146, the second transistor 122 creates a second blocking impedance between the second drain terminal 148 and the second source terminal 146. As a result of the second blocking impedance being created, the second transistor 122 changes to the passive state. In an example, the above explanations, advantageous features and effects may be applied in an analogous manner to the third transistor 126 and the fourth transistor 130. For example, the third transistor 126 may create a third blocking impedance by applying a third switch-off voltage, so that the third transistor 126 changes to the passive state. In a further example, the fourth transistor 130 may create a fourth blocking impedance by applying a fourth switch-off voltage, so that the fourth transistor 130 changes to the passive state. The first to fourth switch-off voltages may be the same. Further, the first to fourth blocking impedance may be the same. In an example, the control unit 166 may be configured to individually drive each of the transistors 116, 122, 126, 130 to the passive state by creating the respective switch-off voltage. In an example, the switch-off voltage may be -2V, 0V, or another predefined voltage. The switch-off voltage may be individually selected and/or predefined for each of transistors 116, 122, 126, 130. The switch-off voltage may also depend on the respective type of transistor 116, 122, 126, 130. In particular, the switch-off voltage may depend on whether the respective transistor 116, 122, 126, 130 is an enhancement type or a depletion type. Furthermore, the switch-off voltage may be dependent on whether the respective transistor 116, 122, 126, 130 is a P-MOS transistor or an N-MOS transistor. Each blocking impedance may comprise at least 100 kOhm, at least 500 kOhm, or at least 1 MOhm.

To generate a first differential output voltage between the two output terminals 108, 110, the control unit 166 may be configured to drive the third and fourth transistors 126, 130 to a passive state and to drive the first and second transistors 116, 122 to an active state. The control unit 166 may, for example, generate a third switch-off voltage at the third gate terminal 162 and a fourth switch-off voltage at the fourth gate terminal 156, so that the third and fourth transistors 126, 130 are driven into the passive state. In the following, an example is explained how the first and second transistors 116, 122 in particular may be driven into the active state. It should be noted that, in principle, each of the transistors 116, 122, 126, 130 may be driven into the active state. Therefore, the following explanations may apply to all transistors 116, 122, 126, 130.

Each of the transistors 116, 122, 126, 130 may be configured, if an associated switch-on voltage is applied between the respective gate terminal 144, 150, 156, 162 and the respective source terminal 140, 146, 152, 158, to create a conducting impedance between the respective drain terminal 142, 148, 154, 160 and the respective source terminal 140, 146, 152, 158, so that the respective transistor 116, 122, 126, 130 is in the active state. A conducting impedance may be so small as to form a conductive channel. Each conducting impedance may be, for example, less than 10 kohm, less than 5 kohm, less than 1 kohm, or less than 500 ohm. In another example, each conducting impedance may be less than 10%, less than 3%, less than 1% of the impedance of the first or second resistor 134, 138. Therefore, a conductive channel with a small conducting impedance may be created by each transistor 116, 122, 126, 130 when being in the active state. The aforementioned features may be customized for each transistor 116, 122, 126, 130 individually. For example, the first transistor 116 may be configured such that if a predefined first switch-on voltage is applied between the first gate terminal 144 and the first source terminal 140, the first transistor 116 creates a first conducting impedance between the first drain terminal 142 and the first source terminal 140. As a result of the first conducting impedance being created, the first transistor 116 changes to the active state. In an example, the second transistor 122 may be configured such that, if a predefined second switch-on voltage is applied between the second gate terminal 150 and the second source terminal 146, the second transistor 122 creates a second conducting impedance between the second drain terminal 148 and the second source terminal 146. As a result of the second conducting impedance being created, the second transistor 122 changes to the active state. In an example, the foregoing explanations, advantageous features, and effects may be applied in an analogous manner to the third transistor 126 and the fourth transistor 130. For example, the third transistor 126 may create a third conducting impedance by applying a third switch-on voltage to the third gate terminal 162, such that the third transistor 126 changes to the active state. In another example, the fourth transistor 130 may be configured to create a fourth conducting impedance by applying a fourth switch-on voltage to the fourth gate terminal 156, so that the fourth transistor 130 changes to the active state. The first to fourth switch-on voltages may be the same. Furthermore, the first to fourth conducting impedance may be the same. In an example, the control unit 166 may be configured to individually drive each of the transistors 116, 122, 126, 130 to the active state by generating the respective switch-on voltage. In an example, the switch-on voltage may be 5 V, 10 V, or another predefined voltage. The switch-on voltage may be individually selected and/or predefined for each transistor 116, 122, 126, 130. The switch-on voltage may also depend on the respective type of transistor 116, 122, 126, 130. In particular, the switch-on voltage may be dependent on whether the respective transistor 116, 122, 126, 130 is an enhancement type or a depletion type. Furthermore, the switch-on voltage may be dependent on whether the respective transistor 116, 122, 126, 130 is a P-MOS transistor or an N-MOS transistor.

In an example, the conducting impedance of each transistor 116, 122, 126, 130 is less than the first impedance (of the first resistor 134) and/or less than the second impedance (of the second resistor 138). For example, the first conducting impedance of the first transistor 116 may be less than the first impedance 134 of the first resistor 134. The second conducting impedance of the second transistor 122 may be less than the second impedance of the second resistor 138. To generate a first differential voltage between the two output terminals 108, 110, the controller 166 may be configured to drive the first and second transistors 116, 122 into the active state and the third and fourth transistors 126, 130 into the passive state. As an effect, the transmitter 102 may be in the first operating state. In Figure 3, a possible first current path during the first operating state is schematically shown through the first dotted line 210. Along the dotted line 210, the associated current may flow from the DC voltage source 182 via the first input terminal 104, the first transistor 116, the first node 114, and the first resistor 134 to the first output terminal 108. Furthermore, the current may flow via the bus to the second output terminal 110. From the output terminal 110, the current may flow via the second resistor 138, the second node 120, the second transistor 122, and the second input terminal 106 to the DC voltage source 182. It was previously explained that, for example, the first conducting impedance of the first transistor 116 may be less than the first impedance of the first resistor 134 and the second conducting impedance of the second transistor 122 may be less than the second impedance of the second resistor 138. As an effect, a substantially greater voltage drops across the first and second resistors 134, 138, respectively, than across each of the two transistors 116, 122. As a further effect, both transistors 116, 122 may be manufactured with a low voltage robustness. Due to the low voltage robustness requirement, both transistors 116, 122 may be manufactured in a compact and cost-effective manner.

To generate a second differential voltage between the two output terminals 108, 110, the controller 166 may be configured to drive the first and second transistors 116, 122 into the passive state and the third and fourth transistors 126, 130 into the active state. As an effect, the transmitter 102 may be in the second operating state. In Figure 4, a possible current path during the second operating state is schematically shown through the second dotted line 212. Along the dotted line 212, the associated current may flow from the DC voltage source 182 via the first input terminal 104, the third transistor 130, the second node 120, the second resistor 138 to the second output terminal 110. From the second output terminal 110, the current may flow via the bus 193 to the first output terminal 108. From the first output terminal 108, the current may flow via the first resistor 134, the first node 114, the third transistor 126, the second input terminal 106 to the DC voltage source 182. It was previously explained that, for example, the third conducting impedance of the third transistor 126 may be less than the first impedance of the first resistor 134 and the fourth conducting impedance of the fourth transistor 130 may be less than the second impedance of the second resistor 138. As an effect, a substantially greater voltage drops across the first and second resistors 134, 138, respectively, than across each of the two transistors 126, 130. As a further effect, both transistors 126, 130 may be manufactured with a low voltage robustness. Due to the low voltage robustness requirement, both transistors 126, 130 may be manufactured in a compact and cost effective manner.

In an example, the first impedance of the first resistor 134 is at least ten times, at least thirty times or at least one hundred times greater than the conducting impedance of each transistor 116, 122, 126, 130, in particular than the first conducting impedance of the first transistor 116 or the third conducting impedance of the third transistor 126. The second impedance of the second resistor 138 may be at least ten times, at least thirty times or at least one hundred times greater than the conducting impedance of each transistor 116, 122, 126, 130, in particular than the second conducting impedance of the second transistor 122 or the fourth conducting impedance of the fourth transistor 130. Since the first and second impedances may be significantly greater than any conducting impedance, only very small voltage drops may be achieved across transistors 116, 122, 126, 130. In an example, transistors 116, 122, 126, 130 may be configured to comprise a maximum of 5V of robustness. This allows transistors 116, 122, 126, 130 to be implemented particularly efficiently in an integrated circuit.

Each transistor 116, 122, 126, 130 may be driven to the active state or to the passive state via the associated gate terminal 144, 150, 156, 162, in particular by the control unit 166. If the transistor 116, 122, 126, 130 is in the active state, then the transistor 116, 122, 126, 130 may comprise the respective conducting impedance between the associated source terminal and drain terminal. If the transistor 116, 122, 106, 20, 130 is in the passive state, then the transistor 116, 122, 126, 130 may comprise the respective blocking impedance between the associated source and drain terminals. The blocking impedance is significantly greater than the conducting impedance. In an example, the blocking impedance of a transistor 116, 122, 126, 130 is at least 1000 times, at least 10,000 times, or at least 100,000 times the conducting impedance of the transistor 116, 122, 126, 130.

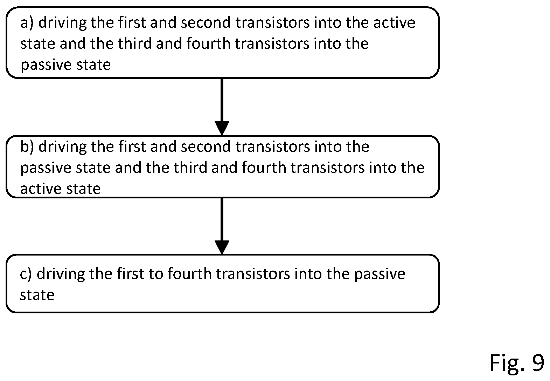

Figure 9 is an example of a flow chart for a method 250 for the transmitter 102. The method 250 comprises the following steps:
a) driving the first and second transistors 116, 122 into the active state and the third and fourth transistors 126, 130 into the passive state,
b) driving the first and second transistors 116, 122 into the passive state and the third and fourth transistors 126, 130 into the active state, and
c) driving the first to fourth transistors 116, 122, 126, 130 into the passive state.

For the method 250 reference is made to the prior discussions, advantageous features, technical effects and advantages in a manner analogous as discussed in connection with Figures 1-8.

Although the described exemplary embodiments disclosed herein focus on devices, systems, and methods for using same, the present disclosure is not necessarily limited to the example embodiments illustrate herein.

The systems and methods described herein may at least partially be embodied by a computer program or a plurality of computer programs, which may exist in a variety of forms both active and inactive in a single computer system or across multiple computer systems. For example, they may exist as software program(s) comprised of program instructions in source code, object code, executable code or other formats for performing some of the steps. Any of the above may be embodied on a computer-readable medium, which may include storage devices and signals, in compressed or uncompressed form.

As used herein, the term "computer" refers to any electronic device comprising a processor, such as a general-purpose central processing unit (CPU), a specific-purpose processor or a microcontroller. A computer is capable of receiving data (an input), of performing a sequence of predetermined operations thereupon, and of producing thereby a result in the form of information or signals (an output). Depending on the context, the term "computer" will mean either a processor in particular or more generally a processor in association with an assemblage of interrelated elements contained within a single case or housing.

The term "processor" or "processing unit" refers to a data processing circuit that may be a microprocessor, a co-processor, a microcontroller, a microcomputer, a central processing unit, a field programmable gate array (FPGA), a programmable logic circuit, and/or any circuit that manipulates signals (analog or digital) based on operational instructions that are stored in a memory. The term "memory" refers to a storage circuit or multiple storage circuits such as read-only memory, random access memory, volatile memory, non-volatile memory, static memory, dynamic memory, Flash memory, cache memory, and/or any circuit that stores digital information.

As used herein, a "computer-readable medium" or "storage medium" may be any means that can contain, store, communicate, propagate, or transport a computer program for use by or in connection with the instruction execution system, apparatus, or device. The computer-readable medium may be, for example but not limited to, an electronic, magnetic, optical, electromagnetic, infrared, or semiconductor system, apparatus, device, or propagation medium. More specific examples (non-exhaustive list) of the computer-readable medium may include the following: an electrical connection having one or more wires, a portable computer diskette, a random-access memory (RAM), a read-only memory (ROM), an erasable programmable read-only memory (EPROM or Flash memory), an optical fiber, a portable compact disc read-only memory (CDROM), a digital versatile disc (DVD), a Blu-ray disc (BD), and a memory card.

It is noted that the embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Furthermore, it is noted that the drawings are schematic. In different drawings, similar or identical elements are provided with the same reference signs. Furthermore, it is noted that in an effort to provide a concise description of the illustrative embodiments, implementation details which fall into the customary practice of the skilled person may not have been described. It should be appreciated that in the development of any such implementation, as in any engineering or design project, numerous implementation-specific decisions must be made in order to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill.

Finally, it is noted that the skilled person will be able to design many alternative embodiments without departing from the scope of the appended claims. In the claims, any reference sign placed between parentheses shall not be construed as limiting the claim. The word "comprise(s)" or "comprising" does not exclude the presence of elements or steps other than those listed in a claim. The word "a" or "an" preceding an element does not exclude the presence of a plurality of such elements. Measures recited in the claims may be implemented by means of hardware comprising several distinct elements and/or by means of a suitably programmed processor. In a device claim enumerating several means, several of these means may be embodied by one and the same item of hardware. The mere fact that certain measures are recited in mutually different dependent claims does not indicate that a combination of these measures cannot be used to advantage.

Unless stated otherwise, terms such as "first" and "second" are used to arbitrarily distinguish between the elements such terms describe. Thus, these terms are not necessarily intended to indicate temporal or other prioritization of such elements.

## Claims

1. A **circuit** for a transmitter, the circuit comprising:
a first supply terminal,
a second supply terminal,
a first output terminal, and
a second output terminal,
wherein a first circuit string extends from the first supply terminal to a first node of the circuit, wherein a first transistor is integrated in the first circuit string,
wherein a second circuit string extends from the second supply terminal to a second node of the circuit, wherein a second transistor is integrated in the second circuit string,
wherein a third circuit string extends from the second supply terminal to the first node of the circuit, wherein a third transistor is integrated in the third circuit string,
wherein a fourth circuit string extends from the first supply terminal to the second node of the circuit, wherein a second transistor is integrated in the second circuit string,
wherein a first connection string extends from the first node to the first output terminal, wherein a first resistor is integrated into the first connection string, and
wherein a second connection string extends from the second node to the second output terminal, wherein a second resistor is integrated into the second connection string.

2. The circuit according to the preceding claim, wherein each transistor is configured, if a predefined switch-on voltage is applied between a gate terminal of the transistor and a source terminal of the transistor, to form an electrically conductive channel between a source terminal and a drain terminal of the transistor resulting in an active state of the transistor, wherein the conductive channel comprising a predefined electrical conducting impedance.

3. The circuit according to the preceding claim, wherein the conducting impedance of the first transistor is less than a first impedance of the first resistor, and wherein the conducting impedance of the second transistor is less than a second impedance of the second resistor.

4. The circuit according to the preceding claim, wherein the first impedance is at least ten times, at least thirty times or at least hundred times higher than the conducting impedance of the conductive channel of the first transistor, and wherein the second impedance is at least ten times, at least thirty times or at least hundred times higher than the conducting impedance of the conductive channel of the second transistor.

5. The circuit according to any of the preceding claims, wherein the first transistor is configured as a P-MOS transistor comprising a source terminal being coupled to the first supply terminal, wherein the second transistor is configured as a N-MOS transistor comprising a source terminal being coupled to the second supply terminal, wherein the third transistor is configured as a N-MOS transistor comprising a source terminal being coupled to the second supply terminal, and wherein the fourth transistor is configured as a N-MOS transistor comprising a source terminal being coupled to the first supply terminal.

6. The circuit according to any of the preceding claims, wherein a capacitor referred to as a decoupling capacitor is coupled between the first supply terminal and the second supply terminal.

7. A **transmitter** comprising:
a circuit according to any of the preceding claims, and
a control unit,
wherein the gate terminal of each transistor is coupled to the control unit such that each transistor can be controlled by the control unit into each of the following two states: an active state and a passive state.

8. The transmitter according to the preceding claim,
wherein the conducting impedance of the conductive channel is present at each transistor being in the active state,
wherein each of the first and fourth transistor comprising an integrated freewheeling diode with a first transmission direction from its drain terminal to its source terminal,
wherein each of the second and third transistor comprising an integrated freewheeling diode with a second transmission direction from its source terminal to its drain terminal, and
wherein each transistor is configured, if a predefined switch-off voltage is applied between the gate terminal of the transistor and a source terminal of the transistor, to create a blocking impedance between the drain terminal and the source terminal of the transistor resulting in the passive state of the transistor.

9. The transmitter according to the preceding claim, wherein the blocking impedance is at least one thousand times, at least ten thousand times, or at least one hundred thousand times the conducting impedance.

10. The transmitter according to any of the preceding claims 7 to 9, wherein a supply voltage source is coupled between the first supply terminal and the second supply terminal, and wherein the supply voltage source is configured to provide a predefined supply voltage between the two supply terminals.

11. The transmitter according to any of the preceding claims 7 to 10, wherein the control unit is configured to drive the first and second transistors into the active state and to drive the third and fourth transistors into the passive state resulting in a positive differential voltage between the first and second output terminals.

12. The transmitter according to any of the preceding claims 7 to 11, wherein the control unit is configured to drive the first and second transistors into the passive state and to drive the third and fourth transistors into the active state resulting in a negative differential voltage between the first and second output terminals.

13. The transmitter according to any of the preceding claims 7 to 12, wherein a common mode voltage source is coupled between the first output terminal and the second output terminal, wherein the common mode voltage source is configured to provide a predefined common mode voltage at both output terminals.

14. A **method** for a transmitter according to any of the preceding claims 7 to 13, wherein the method comprises the steps of:
a) driving the first and second transistors into the active state and the third and fourth transistors into the passive state,
b) driving the first and second transistors into the passive state and the third and fourth transistors into the active state, and
c) driving the first to fourth transistors into the passive state.

15. The method of claim 14, wherein each transistor is configured, if a predefined switch-on voltage is applied between a gate terminal of the transistor and a source terminal of the transistor, to form an electrically conductive channel between a source terminal and a drain terminal of the transistor resulting in an active state of the transistor, wherein the conductive channel comprising a predefined electrical conducting impedance, wherein the conducting impedance of the first transistor is less than a first impedance of the first resistor, and wherein the conducting impedance of the fourth transistor is less than a second impedance of the second resistor.
